Europäisches Patentamt

European Patent Office

Office européen des brevets

(19)

(11) **EP 1 598 870 A1**

(12) **EUROPEAN PATENT APPLICATION**
published in accordance with Art. 158(3) EPC

(43) Date of publication:
**23.11.2005 Bulletin 2005/47**

(51) Int Cl.7: **H01L 27/04**, H01L 27/10,
H01G 4/33, H01G 4/12,
C04B 35/453, C01G 29/00

(21) Application number: **04713200.6**

(22) Date of filing: **20.02.2004**

(86) International application number:
**PCT/JP2004/001977**

(87) International publication number:
**WO 2004/077564 (10.09.2004 Gazette 2004/37)**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **26.02.2003 JP 2003049623**

(71) Applicant: **TDK Corporation
Tokyo 103-8272 (JP)**

(72) Inventor: **SAKASHITA, Yukio,
c/o TDK Corporation
Tokyo 103-8272 (JP)**

(74) Representative: **HOFFMANN EITLE
Patent- und Rechtsanwälte
Arabellastrasse 4
81925 München (DE)**

(54) **THIN-FILM CAPACITATIVE ELEMENT AND ELECTRONIC CIRCUIT OR ELECTRONIC EQUIPMENT INCLUDING THE SAME**

(57)    A thin film capacitive element according to the present invention includes between a first electrode layer and a second electrode layer a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$ but containing bismuth (Bi) in such an amount exceeding that determined by the stoichiometric ratio that bismuth (Bi) is excessive in an amount larger than 0 and smaller than $0.5m$ mole in terms of bismuth (Bi), where the symbol $m$ is a positive integer, the symbol $A$ is at least one element selected from a group consisting of sodium, potassium, lead, barium, strontium, calcium and bismuth, and the symbol $B$ is at least one element selected from a group consisting of iron, cobalt, chromium, gallium, titanium, niobium, tantalum, antimony, vanadium, molybdenum and tungsten.

The thin film capacitive element having the above identified configuration can be made thin, can be fabricated easily and has an excellent temperature compensating characteristic.

FIG. 1

EP 1 598 870 A1

**Description**

## BACKGROUND OF THE INVENTION

The present invention relates to a thin film capacitive element, and an electronic circuit and an electronic device including the same and, particularly, to a thin film capacitive element which can be made thin and fabricated easily and has an excellent temperature compensating characteristic, and an electronic circuit and an electronic device including the thin film capacitive element.

## DESCRIPTION OF THE PRIOR ART

Since it is preferable for an electronic circuit included in an electronic device to have a low temperature dependency, numerous attempts for reducing the temperature dependency of an electronic circuit by controlling the electrostatic capacitance temperature coefficient of a capacitive element included in the electronic circuit has been recently made.

For example, each of Japanese Patent Application Laid Open No. 2002-289462, Japanese Patent Application Laid Open No. 2002-75783 and Japanese Patent Application Laid Open No. 2002-252143 proposes a thin film capacitive element whose electrostatic capacitance temperature coefficient is controlled in a desired manner by forming a plurality of dielectric layers of dielectric materials having different electrostatic capacitance temperature coefficients between an upper electrode and a lower electrode.

However, in the case of forming dielectric materials having different electrostatic capacitance temperature coefficients, thereby controlling the electrostatic capacitance temperature coefficient of a thin film capacitive element, not only does the process for fabricating the thin film capacitive element become complicated and the thickness of the thin film capacitive element inevitably increase but it also becomes necessary to precisely control the thickness of each of the dielectric layers for controlling the electrostatic capacitance temperature coefficient of the thin film capacitive element in a desired manner.

## SUMMARY OF THE INVENTION

It is therefore an object of the present invention to provide a thin film capacitive element which can be made thin and has an excellent temperature compensating characteristic, and an electronic circuit and an electronic device including the thin film capacitive element.

The inventor of the present invention vigorously pursued a study for accomplishing the above object and, as a result, made the surprising discovery that the electrostatic capacitance temperature coefficient of a thin film capacitive element including a dielectric layer formed of a dielectric material containing a bismuth layer structured compound having a specific stoichiometric composition and containing bismuth in an amount exceeding that determined by the stoichiometric ratio depended upon the degree of the orientation of the bismuth layer structured compound in the [001] direction, namely, the degree of the orientation of the bismuth layer structured compound in the c axis direction thereof and that the electrostatic capacitance temperature coefficient of a thin film capacitive element can be controlled in a desired manner by controlling the degree of the orientation of the bismuth layer structured compound contained in the dielectric layer in the c axis direction thereof.

The present invention is based on these findings and according to the present invention, the above object of the present invention can be accomplished by a thin film capacitive element including between a first electrode layer and a second electrode layer a dielectric layer formed of a dielectric material containing a bismuth layer structured compound having a composition represented by the stoichiometric compositional formula: $(Bi_2O_2)^{2+} (A_{m-1}B_mO_{3m+1})^{2-}$ or $Bi_2A_{m-1}B_mO_{3m+3}$ but containing bismuth (Bi) in such an amount exceeding that determined by the stoichiometric ratio, that bismuth (Bi) is excessive in an amount larger than 0 and smaller than $0.5m$ mole in terms of bismuth (Bi), where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

In the present invention, the dielectric material containing the bismuth layer structured compound may contain unavoidable impurities.

According to the present invention, it is possible to control the degree of orientation in the [001] direction of the bismuth layer structured compound contained in a dielectric layer, namely, the degree of the orientation of the bismuth layer structured compound in the $c$ axis direction thereof when the dielectric layer is formed, thereby determining the electrostatic capacitance temperature coefficient of a thin film capacitive element containing the dielectric layer to a desired value and it is therefore possible to control the temperature coefficient of an electronic circuit into which the thin film capacitive element is incorporated in a desired manner and further control the temperature coefficient of an electronic device into which the electronic circuit including the thin film capacitive element is incorporated in a desired manner.

The degree of $c$ axis orientation of a bismuth layer structured compound can be controlled by controlling the excessive amount of bismuth (Bi) with respect to the stoichiometric ratio, the kind of substrate used for the thin film capacitive element, the kind of electrode used for the thin film capacitive element, the process for forming the thin film capacitive element and conditions for forming the thin film capacitive element. For example, in the case of forming a dielectric layer using a chemical solution deposition process, the degree of *c* axis orientation of a bismuth layer structured compound can be controlled by controlling the coating conditions, provisional baking conditions and baking conditions for forming the dielectric layer.

In the present invention, the degree of *c* axis orientation of a bismuth layer structured compound is defined by the following formula (1).

$$F = (P - P_0)/(1 - P_0) \times 100 \qquad (1)$$

In formula (1), $P_0$ is defined as a *c* axis orientation ratio of a bismuth layer structured compound whose orientation is completely random, namely, the ratio of the sum $\Sigma I_0 (00\mathbf{1})$ of reflection intensities $I_0 (00\mathbf{1})$ from the surface of [00$\mathbf{1}$] of the bismuth layer structured compound whose orientation is completely random to the sum $\Sigma I_0 (hkl)$ of reflection intensities $I_0 (hkl)$ from the respective crystal surfaces of *[hkl]* thereof $(\Sigma I_0 (00l) / \Sigma I_0 (hkl))$, and *P* is defined as the *c* axis orientation ratio of the bismuth layer structured compound calculated using the X-ray diffraction intensity thereof, namely, the ratio of the sum $\Sigma I (00\mathbf{1})$ of reflection intensities *I* (00$\mathbf{1}$) from the surface of [00$\mathbf{1}$] of the bismuth layer structured compound to the sum $\Sigma I (hkl)$ of reflection intensities *I (hkl)* from the respective crystal surfaces of *[hkl]* thereof $(\Sigma I (00\mathbf{1}/ \Sigma I (hkl).$ The symbols *h, k* and *l* can each assume an arbitrary integer value equal to or larger than 0.

In the above formula (1), since $P_0$ is a known constant, when the sum $\Sigma I(00l)$ of reflection intensities *I* (00$\mathbf{1}$) from the surface of [00$\mathbf{1}$] of the bismuth layer structured compound and the sum $\Sigma I(hkl)$ of reflection intensities *I(hkl)* from the respective crystal surfaces of *[hkl]* are equal to each other, the degree *F* of the *c* axis orientation of the bismuth layer structured compound is equal to 100 %.

The bismuth layer structured compound has a layered structure formed by alternately laminating perovskite layers each including perovskite lattices made of (m - 1) $\boldsymbol{ABO_3}$ and $(Bi_2O_2)^{2+}$ layers.

The *c* axis of the bismuth layer structured compound means the direction obtained by connecting the pair of $(Bi_2O_2)^{2+}$ layers, namely, the [001] direction.

In the present invention, the symbol *m* in the stoichiometric compositional formula is not particularly limited insofar as it is a positive integer but the symbol *m* is preferably an even number. In the case where the symbol *m* is an even number, the dielectric thin film 6 has a mirror plane of symmetry perpendicular to the *c* axis, so that spontaneous polarization components in the *c* axis direction cancel each other on opposite sides of the mirror plane of symmetry, whereby the dielectric thin film has no polarization axis in the c axis direction. As a result, it is possible to maintain the paraelectric property of the dielectric thin film, to improve the temperature coefficient of the dielectric constant and to lower loss. If the symbol *m* is large, the dielectric constant of the dielectric thin film 6 tends to increase.

In the present invention, the symbol *m* in the stoichiometric compositional formula is preferably 2, 4, 6 or 8 and the symbol *m* is more preferably 2 or 4.

In a preferred aspect of the present invention, the dielectric layer contains a bismuth layer structured compound containing bismuth (Bi) in such an amount exceeding that determined by the stoichiometric ratio, that the excessive amount of bismuth (Bi) is equal to or larger than 0.4*m* mole and smaller than 0.5*m* mole in terms of bismuth (Bi).

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be accomplished by a thin film capacitive element including between a first electrode layer and a second electrode layer a dielectric layer formed of a dielectric material having a composition represented by the stoichiometric compositional formula: $x\mathrm{SbBi_4Ti_4O_{15}}$-$(1 - x)M\mathrm{Bi_4Ti_4O_{15}}$ but containing bismuth (Bi) in such an amount exceeding that determined by the stoichiometric ratio, that bismuth (Bi) is excessive in an amount larger than 0 and smaller than 2.0 mole in terms of bismuth, where the symbol *M* is at least one element selected from among calcium, barium and lead and the symbol *x* is equal to or larger than 0 and equal to or smaller than 1.

In a preferred aspect of the present invention, the dielectric layer contains a bismuth layer structured compound represented by the stoichiometric compositional formula: $\mathrm{SrBi_4Ti_4O_{15}}$.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic circuit including between a first electrode layer and a second electrode layer a dielectric layer formed of a dielectric material having a composition represented by the stoichiometric compositional formula: $x$SbBi$_4$Ti$_4$O$_{15}$-(1 - $x$)$M$B$_{14}$Ti$_4$O$_{15}$ but containing bismuth (Bi) in such an amount exceeding that determined by the stoichiometric ratio that the mole ratio (Bi/Ti) of bismuth (Bi) to titanium (Ti) is larger than 1 and smaller than 1.5, where the symbol $M$ is at least one element selected from among calcium, barium and lead and the symbol $x$ is equal to or larger than 0 and equal to or smaller than 1.

In a preferred aspect of the present invention, the dielectric layer contains a bismuth layer structured compound represented by the stoichiometric compositional formula: SrBi$_4$Ti$_4$O$_{15}$.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be accomplished by an electronic circuit including a thin film capacitive element including between a first electrode layer and a second electrode layer a dielectric layer formed of a dielectric material containing a bismuth layer structured compound having a composition represented by the stoichiometric compositional formula: (Bi$_2$O$_2$)$^{2+}$ ($A_{m-1}B_m$O$_{3m+1}$)$^{2-}$ or Bi$_2A_{m-1}B_m$O$_{3m+3}$ but containing bismuth (Bi) in such an amount exceeding that determined by the stoichiometric ratio, that bismuth (Bi) is excessive in an amount larger than 0 and smaller than 0.5$m$ mole in terms of bismuth (Bi), where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

According to the present invention, since the electrostatic capacitance temperature coefficient of a thin film capacitive element in which a dielectric layer is formed of a dielectric material containing a bismuth layer structured compound having a composition represented by the above mentioned stoichiometric compositional formula but containing bismuth (Bi) in an amount exceeding that determined by the stoichiometric ratio depends upon the degree of the orientation of the bismuth layer structured compound contained in a dielectric layer in the [001] direction, namely, the degree of the orientation of the bismuth layer structured compound in the $c$ axis direction thereof, it is possible to control the electrostatic capacitance temperature coefficient of a thin film capacitive element in a desired manner by controlling the degree of the orientation of the bismuth layer structured compound contained in a dielectric layer in the c axis direction thereof. Therefore, if a thin film capacitive element including a dielectric layer formed of a dielectric material containing the bismuth layer structured compound is incorporated into an electronic circuit, the temperature coefficient of the electronic circuit can be controlled in a desired manner.

In a preferred aspect of the present invention, the dielectric layer contains a bismuth layer structured compound containing bismuth (Bi) in such an amount exceeding that determined by the stoichiometric ratio that the excessive amount of bismuth (Bi) is equal to or larger than 0.4$m$ mole and smaller than 0.5$m$ mole in terms of bismuth (Bi).

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic circuit including a thin film capacitive element including between a first electrode layer and a second electrode layer a dielectric layer formed of a dielectric material containing a bismuth layer structured compound having a composition represented by the stoichiometric compositional formula: $x$SbBi$_4$Ti$_4$O$_{15}$-(1 - $x$) $M$Bi$_4$Ti$_4$O$_{15}$ but containing bismuth (Bi) in such an amount exceeding that determined by the stoichiometric ratio, that bismuth (Bi) is excessive in an amount larger than 0 and smaller than 2.0 mole in terms of bismuth, where the symbol $M$ is at least one element selected from among calcium, barium and lead and the symbol $x$ is equal to or larger than 0 and equal to or smaller than 1.

In a preferred aspect of the present invention, the dielectric layer contains a bismuth layer structured compound represented by the stoichiometric compositional formula: SrBi$_4$Ti$_4$O$_{15}$.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic circuit including a thin film capacitive element including between a first electrode layer and a second electrode layer a dielectric layer formed of a dielectric material containing a bismuth layer structured compound having a composition represented by the stoichiometric compositional formula: $x\mathrm{SbBi_4Ti_4O_{15}}$-$(1-x)$ $M\mathrm{Bi_4Ti_4O_{15}}$ but containing bismuth (Bi) in such an amount exceeding that determined by the stoichiometric ratio that the mole ratio (Bi/Ti) of bismuth (Bi) to titanium (Ti) is larger than 1 and smaller than 1.5, where the symbol $M$ is at least one element selected from among calcium, barium and lead and the symbol $x$ was equal to or larger than 0 and equal to or smaller than 1.

In a preferred aspect of the present invention, the dielectric layer contains a bismuth layer structured compound represented by the stoichiometric compositional formula: $\mathrm{SrBi_4Ti_4O_{15}}$.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic device including a thin film capacitive element including between a first electrode layer and a second electrode layer a dielectric layer formed of a dielectric material containing a bismuth layer structured compound having a composition represented by the stoichiometric compositional formula: $(\mathrm{Bi_2O_2})^{2+}$ $(A_{m-1}B_m\mathrm{O_{3m+1}})^{2-}$ or $\mathrm{Bi_2}A_{m-1}B_m\mathrm{O_{3m+3}}$ but containing bismuth (Bi) in such an amount exceeding that determined by the stoichiometric ratio, that bismuth (Bi) is excessive in an amount larger than 0 and smaller than $0.5m$ mole in terms of bismuth (Bi), where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

According to the present invention, since the electrostatic capacitance temperature coefficient of a thin film capacitive element in which a dielectric layer is formed of a dielectric material containing a bismuth layer structured compound having a composition represented by the above mentioned stoichiometric compositional formula but containing bismuth (Bi) in an amount exceeding that determined by the stoichiometric ratio depends upon the degree of the orientation of the bismuth layer structured compound contained in a dielectric layer in the [001] direction, namely, the degree of the orientation of the bismuth layer structured compound in the $c$ axis direction thereof, it is possible to control the electrostatic capacitance temperature coefficient of a thin film capacitive element in a desired manner by controlling the degree of the orientation of the bismuth layer structured compound contained in a dielectric layer in the c axis direction thereof. Accordingly, if a thin film capacitive element including a dielectric layer formed of a dielectric material containing the bismuth layer structured compound is incorporated into an electronic circuit, the temperature coefficient of the electronic circuit can be controlled in a desired manner and it is therefore possible to control in a desired manner the temperature coefficient of an electronic device including an electronic circuit into which a thin film capacitive element including a dielectric layer formed of a dielectric material containing the bismuth layer structured compound is incorporated.

In a preferred aspect of the present invention, the dielectric layer contains a bismuth layer structured compound containing bismuth (Bi) in such an amount exceeding that determined by the stoichiometric ratio that bismuth (Bi) is excessive in an amount equal to or larger than $0.4m$ mole and smaller than $0.5m$ mole in terms of bismuth (Bi).

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic device including a thin film capacitive element including between a first electrode layer and a second electrode layer a dielectric layer formed of a dielectric material containing a bismuth layer structured compound having a composition represented by the stoichiometric compositional formula: $x\mathrm{SbBi_4Ti_4O_{15}}$-$(1-x)$ $M\mathrm{Bi_4Ti_4O_{15}}$ but containing bismuth (Bi) in such an amount exceeding that determined by the stoichiometric ratio, that bismuth (Bi) is excessive in an amount larger than 0 and smaller than 2.0 mole in terms of bismuth, where the symbol $M$ is at least one element selected from among calcium, barium and lead and the symbol *x* is equal to or larger than 0 and equal to or smaller than 1.

In a preferred aspect of the present invention, the dielectric layer contains a bismuth layer structured compound represented by the stoichiometric compositional formula: $SrBi_4Ti_4O_{15}$.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic device including a thin film capacitive element including between a first electrode layer and a second electrode layer a dielectric layer formed of a dielectric material containing a bismuth layer structured compound having a composition represented by the stoichiometric compositional formula: $xSbBi_4Ti_4O_{15}$-$(1 - x)$ $MBi_4Ti_4O_{15}$ but containing bismuth (Bi) in such an amount exceeding that determined by the stoichiometric ratio that the mole ratio (Bi/Ti) of bismuth (Bi) to titanium (Ti) is larger than 1 and smaller than 1.5, where the symbol *M* is at least one element selected from among calcium, barium and lead and the symbol *x* is equal to or larger than 0 and equal to or smaller than 1.

In a preferred aspect of the present invention, the dielectric layer contains a bismuth layer structured compound represented by the stoichiometric compositional formula: $SrBi_4Ti_4O_{15}$.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In the present invention, the material used for forming a first electrode layer on the surface of which a dielectric layer is to be formed is not particularly limited and the first electrode layer can be formed of a metal such as platinum (Pt), ruthenium (Ru), rhodium (Rh), palladium (Pd), iridium (Ir), gold (Au), silver (Ag), copper (Cu), nickel (Ni) or the like, alloy containing at least one of these metals as a principal component, a conductive oxide such as NdO, NbO, $ReO_2$, $RhO_2$, $OsO_2$, $IrO_2$, $RuO_2$, $ReO_3$, $SrMoO_3$, $SrRuO_3$, $CaRuO_3$, $SrVO_3$, $SrCrO_3$, $SrCoO_3$, $LaNiO_3$, Nb doped $SrTiO_3$ or the like, a mixture of these, a superconductor having a superconductive layered bismuth structure such as

$Bi_2Sr_2CuO_6$, or the like.

In the present invention, the first electrode layer on the surface of which a dielectric layer is to be formed can be formed using any of various thin film forming processes such as a vacuum deposition process, a sputtering process, a pulsed laser deposition process (PLD), a metal organic chemical vapor deposition process (MOCVD), a chemical solution deposition process (CSD process) such as a metal-organic decomposition process (MOD) and a sol-gel process or the like.

In the present invention, the first electrode layer on the surface of which a dielectric layer is to be formed may be oriented in the [001] direction, namely, the c axis direction or in a direction other than the [001] direction and further, the first electrode layer may be amorphous or unoriented.

In the present invention, the dielectric layer can be formed using any of various thin film forming processes such as a vacuum deposition process, a sputtering process, a pulsed laser deposition process (PLD), a metal organic chemical vapor deposition process (MOCVD), a chemical solution deposition process (CSD process) such as a metal-organic decomposition process (MOD) and a sol-gel process or the like.

In the present invention, a chemical solution deposition process means a thin film forming process including one or more coating steps, one or more provisional baking steps and one or more baking steps and includes a metal-organic decomposition process (MOD) and a sol-gel process. The chemical solution deposition process further includes a process for forming a thin film using an inorganic acid salt solution. Among these, a metal-organic decomposition process is most preferable.

During the process of forming the dielectric layer on the first electrode layer, the dielectric material containing a bismuth layer structured compound is epitaxially grown on the first electrode layer and the degree *F* of orientation of the bismuth layer structured compound in the [001] direction, namely, the c axis direction is determined by selecting the composition of the bismuth layer structured compound and the conditions for forming the dielectric layer.

In the case of forming the dielectric layer using a metal-organic decomposition process, a solution of a composition prepared for forming a thin film capacitive element and containing a bismuth layer structured compound containing bismuth (Bi) in an amount exceeding that determined by the stoichiometric ratio is applied onto the first electrode layer to form a coating layer and the coating layer on the first electrode layer is baked, thereby forming a dielectric layer.

In the present invention, a dielectric layer is preferably formed by forming a coating layer on a first electrode layer, drying the coating layer, provisionally baking the coating layer at a temperature under which the coating layer cannot be crystallized and further baking the coating layer

Alternatively, a dielectric layer may be formed by forming a coating layer on a first electrode layer, drying the coating layer, forming a new coating layer on the thus dried coating layer, drying the new coating layer, repeating these steps of forming new coating layers and drying them to form a coating layer having a predetermined thickness and then baking the coating layer. In this case, a dielectric layer may be formed by repeating coating and drying steps two or more times, provisionally baking the coating layer and finally baking the coating layer.

Alternatively, a dielectric layer may be formed by forming a coating layer on a first electrode layer, drying the coating layer, provisionally baking the coating layer, forming a new coating layer on the thus provisionally baked coating layer, drying the new coating layer, provisionally baking the new coating layer, repeating these steps of forming, drying and provisionally baking new coating layers to form a coating layer having a predetermined thickness and then baking the coating layer. In this case, a dielectric layer may be formed by repeating coating and provisional baking steps without drying the coating layers and finally baking the coating layer.

Alternatively, a dielectric layer may be formed by forming a coating layer on a first electrode layer, drying the coating layer, provisionally baking the coating layer and baking the coating layer, repeating these steps to form a coating layer having a predetermined thickness. In this case, a dielectric layer may be formed by repeating steps of coating, provisionally baking and baking a coating layer without drying the coating layer or a dielectric layer may be formed by repeating steps of coating, drying and baking a coating layer without provisionally baking the coating layer.

In the present invention, in the case of forming the dielectric layer using a metal-organic decomposition process, a solution of a composition prepared for forming a thin film capacitive element and containing a bismuth layer structured compound containing bismuth (Bi) in an amount exceeding that determined by the stoichiometric ratio is applied onto the first electrode layer using a spin coating process or a dip coating process, preferably a spin coating process, thereby forming a coating layer.

In the present invention, a coating layer formed on a first electrode layer is preferably baked at a temperature of 700 to 900 °C which is a crystalline temperature of a bismuth layer structured compound.

In the present invention, a coating layer formed on a first electrode layer is preferably dried at a temperature of room temperature to 400 °C and more preferably dried at a temperature of 50 to 300 °C.

In the present invention, a coating layer formed on a first electrode layer is preferably provisionally baked at a temperature of 300 to 500 °C.

In the present invention, after a dielectric layer has been formed on a first electrode layer, a second electrode layer is formed on the dielectric layer.

In the present invention, the material used for forming a second electrode layer is not particularly limited insofar as it is conductive and the second electrode layer can be formed of a metal such as platinum (Pt), ruthenium (Ru), rhodium (Rh), palladium (Pd), iridium (Ir), gold (Au), silver (Ag), copper (Cu), nickel (Ni) or the like, alloy containing at least one of these metals as a principal component, a conductive oxide such as $NdO$, $NbO$, $ReO_2$, $RhO_2$, $OsO_2$, $IrO_2$, $RuO_2$, $ReO_3$, $SrMoO_3$, $SrRuO_3$, $CaRuO_3$, $SrVO_3$, $SrCrO_3$, $SrCoO_3$, $LaNiO_3$, Nb doped $SrTiO_3$ or the like, a mixture of these, conductive glass such as ITO, or the like. Further, unlike in the case of the first electrode layer, since it is unnecessary to consider the lattice matching characteristic of the second electrode layer with a material for forming a dielectric layer and the second electrode layer can be formed at a room temperature, a base metal such as iron (Fe), nickel (Ni) or the like, or an alloy such as WSi, MoSi or the like can be used for forming the second electrode layer.

In the present invention, the thickness of a second electrode layer is not particularly limited insofar as it can serve as the one of the electrodes of a thin film capacitive element and the second electrode layer can be formed so as to have a thickness of 10 to 10000 nm, for example.

In the present invention, the method used for forming a second electrode layer is not particularly limited and the second electrode layer can be formed using any of various thin film forming processes such as a vacuum deposition process, a sputtering process, a pulsed laser deposition process (PLD), a metal organic chemical vapor deposition process (MOCVD), a chemical solution deposition process (CSD process) such as a metal-organic decomposition process (MOD) and a sol-gel process or the like. Among these, a sputtering process is most preferable for forming the second electrode layer from the viewpoint of the thin film forming rate.

The above and other objects and features of the present invention will become apparent from the following description made with reference to the accompanying drawings.

## BRIEF DESCRIPTION OF THE DRAWINGS

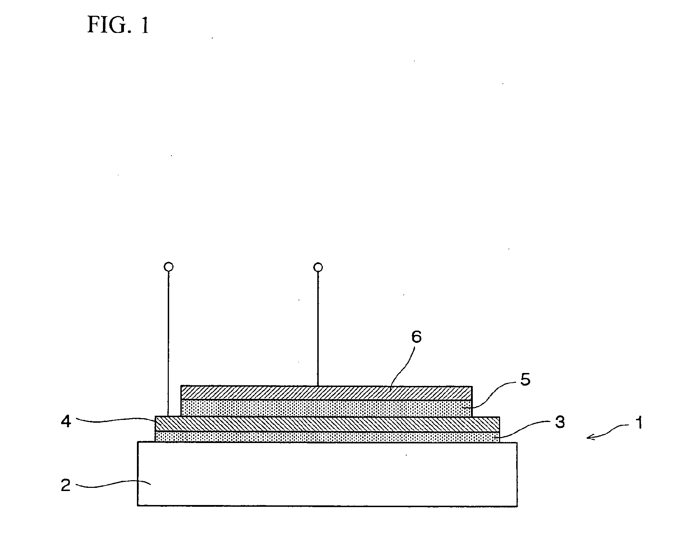

Figure 1 is a schematic cross-sectional view showing a thin film capacitive element which is a preferred embodiment of the present invention.

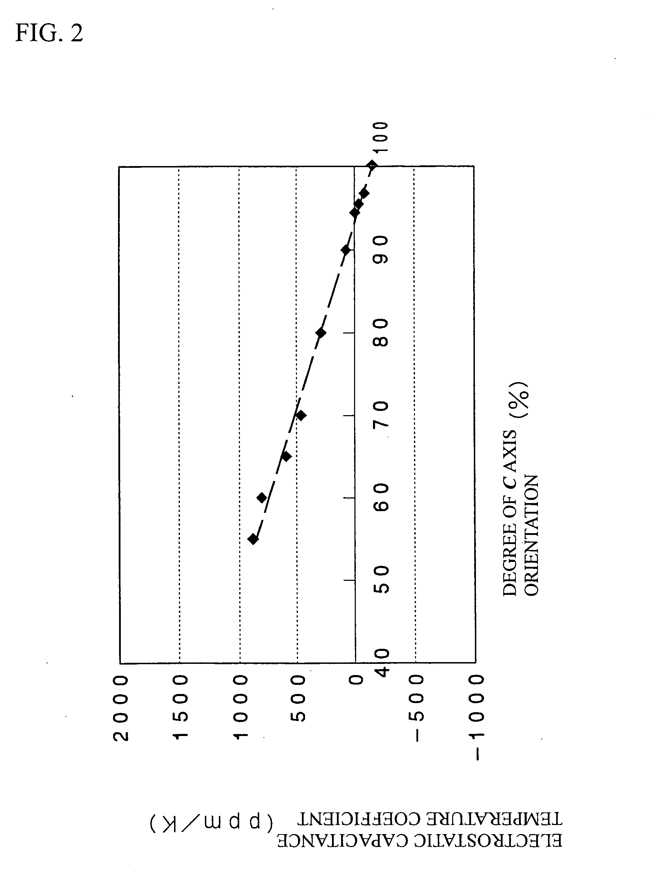

Figure 2 is a graph showing the relationship between the average rate of change in the dielectric constant (electrostatic capacitance temperature coefficient) $\Delta\varepsilon$ of each thin film capacitive element fabricated in Working Examples 1 to 10 with respect to temperature and the degree *F* of *c* axis orientation of the bismuth layer structured compound contained in the dielectric layer for constituting each of the thin film capacitive elements.

## DESCRIPTION OF THE PREFERRED EMBODIMENT

A preferred embodiment of the present invention will now be described with reference to the accompanying drawing.

Figure 1 is a schematic cross-sectional view showing a thin film capacitive element which is a preferred embodiment of the present invention.

As shown in Figure 1, a thin film capacitive element 1 according to this embodiment includes a support substrate 2, and a barrier layer 3, a lower electrode layer 4, a dielectric layer 5 and an upper electrode layer 6 laminated on the support substrate 2 in this order.

In this embodiment, the support substrate 2 of the thin film capacitive element 1 is formed of silicon single crystal having a small lattice matching characteristic. The thickness of the support substrate 2 is set to 100 to 1000 $\mu$m, for example.

The thin film capacitive element 1 includes an insulating layer formed of silicon oxide on the support substrate 2.

The insulating layer 3 made of silicon oxide is formed by, for example, thermal oxidation of silicon.

As shown in Figure 1, the lower electrode layer 4 is formed on the insulating layer 3.

In this embodiment, the lower electrode layer 4 is formed of platinum.

The lower electrode layer 4 may be oriented in the [001] direction or in a direction other than the [001] direction. Further, the lower electrode layer 4 may be amorphous or may be unoriented.

The lower electrode layer 4 made of platinum is formed on the insulating layer 3 by, for example, using a sputtering process with argon gas as the sputtering gas and setting the temperatures of the support substrate 2 and the insulating layer 3 to 300 °C or higher, preferably, 500 °C or higher.

The thickness of the lower electrode layer 4 is not particularly limited and set to about 10 to 1000 nm, preferably, about 50 to 200 nm. In this embodiment, the lower electrode layer 4 is formed so as to have a thickness of 100 nm.

As shown in Figure 1, the thin film capacitive element 1 according to this embodiment includes the dielectric layer 5 formed on the lower electrode layer 4.

In this embodiment, the dielectric layer 5 is formed of a dielectric material containing a bismuth layer structured compound represented by the stoichiometric compositional formula: $SrBi_4Ti_4O_{15}$ and having an excellent characteristic as a capacitor material. The bismuth layer structured compound contains an excessive amount of bismuth such that the mole ratio (Bi/Ti) of bismuth (Bi) to titanium (Ti) is larger than 1 and smaller than 1.5.

The bismuth layer structured compound preferably contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In this embodiment, the dielectric layer 5 is formed on the lower electrode layer 4 using a metal-organic decomposition process (MOD).

Concretely, a toluene solution of strontium 2-ethyl hexanoate, a 2-ethyl hexanoate solution of bismuth 2-ethyl hexanoate and a toluene solution of titanium 2-ethyl hexanoate are mixed so that the mixture contains 1 mole of strontium 2-ethyl hexanoate, $(4 + \alpha)$ moles of bismuth 2-ethyl hexanoate and 4 moles of titanium 2-ethyl hexanoate, namely, so that bismuth (Bi) is present in an amount exceeding that determined by the stoichiometric ratio by $\alpha$ mole, and the resulting mixture is diluted with toluene, thereby preparing a constituent solution.

Here, $\alpha$ is selected so that Bi/Ti lies between 1.1 and 1.5.

The resultant constituent solution is coated on the lower electrode layer 4 using a spin coating method so as to have a thickness of 100 nm, for example, to form a coating layer.

The thus formed coating layer is dried under a temperature between room temperature and about 400 °C, thereby evaporating the solvent contained in the coating layer.

The coating layer is then provisionally baked under an oxygen gas atmosphere at a temperature of about 200 to 700 °C. The provisional baking operation is performed at a temperature under which the bismuth layer structured compound contained in the coating layer cannot be crystallized.

Then, the same constituent solution is again applied using a spin coating process onto the thus provisionally baked coating layer so as to have a thickness of 10 nm, for example, to form a coating layer and the coating layer is dried and provisionally baked under an oxygen gas atmosphere at a temperature of about 200 to 700 °C.

Further, the same constituent solution is again applied using a spin coating process onto the thus provisionally baked coating layer so as to have a thickness of 10 nm, for example, to form a coating layer and the coating layer is dried and provisionally baked under an oxygen atmosphere at a temperature of about 200 to 700 °C.

When the provisional baking operations have been completed in this manner, the provisionally baked coating layers are baked under an oxygen gas atmosphere at a temperature of about 700 to 900 °C, thereby crystallizing the bismuth layer structured compound contained in the coating layers to form the dielectric layer 5 having a thickness of 300 nm, for example.

The thus formed dielectric layer 5 contains a bismuth layer structured compound represented by the stoichiometric compositional formula: $SrBi_4Ti_4O_{15}$ and the bismuth layer structured compound contains bismuth in such an amount exceeding that determined by the stoichiometric ratio that the mole ratio (Bi/Ti) of bismuth (Bi) to titanium (Ti) is larger than 1 and smaller than 1.5.

During the provisional baking and baking processes, the bismuth layer structured compound is epitaxially grown and is oriented in the [001] direction, namely, the *c* axis direction thereof.

It was known that the degree *F* (%) of orientation of a bismuth layer structured compound could be controlled by controlling the excessive amount of bismuth (Bi) with respect to the stoichiometric ratio, coating conditions, provisional baking conditions and baking conditions for forming a dielectric layer 5 and in a study of the inventors of the present invention, it was further found that the electrostatic capacitance temperature coefficient of a thin film capacitive element could be changed by controlling the degree *F* (%) of c axis orientation of a bismuth layer structured compound contained in a dielectric layer 5. In particular, it was found that in the case where a dielectric layer 5 contained a bismuth layer structured compound having a composition represented by the stoichiometric compositional formula: $SrBi_4Ti_4O_{15}$ but containing bismuth (Bi) in such an amount exceeding that determined by the stoichiometric ratio that the mole ratio (Bi/Ti) of bismuth (Bi) to titanium (Ti) was larger than 1 and smaller than 1.5, the electrostatic capacitance temperature coefficient of a thin film capacitive element could be greatly varied between a plus value and a minus value by controlling the degree *F*(%) of *c* axis orientation of the bismuth layer structured compound.

Therefore, in this embodiment, the excessive amount of bismuth (Bi) with respect to the stoichiometric ratio, the coating conditions, provisional baking conditions and baking conditions for forming a dielectric layer 5 are controlled, whereby the degree *F* (%) of c axis orientation of a bismuth layer structured compound contained in a dielectric layer 5 is determined so that a thin film capacitive element has a desired electrostatic capacitance temperature coefficient.

As shown in Figure 1, the upper electrode layer 6 is formed of platinum on the dielectric layer 5.

The upper electrode layer 6 made of platinum is formed on the dielectric layer 5 by, for example, using a sputtering process with argon gas as a sputtering gas and setting the temperatures of the support substrate 2, the insulating layer 3, the lower electrode layer 4 and the dielectric layer to room temperature.

As mentioned above, in a study of the inventor of the present invention, it was further found that the electrostatic capacitance temperature coefficient of a thin film capacitive element could be changed by controlling the degree *F* (%) of *c* axis orientation of a bismuth layer structured compound contained in a dielectric layer 5 and in particular, it was found that in the case where a dielectric layer 5 contained a bismuth layer structured compound having a composition represented by the stoichiometric compositional formula: $SrBi_4Ti_4O_{15}$, the electrostatic capacitance temperature coefficient of a thin film capacitive element could be greatly varied between a plus value and a minus value by controlling the degree *F* (%) of *c* axis orientation of the bismuth layer structured compound.

According to this embodiment, since the dielectric layer 5 contains a bismuth layer structured compound having a composition represented by the stoichiometric compositional formula: $SrBi_4Ti_4O_{15}$ and the coating conditions, provisional baking conditions and baking conditions for forming a dielectric layer 5 are controlled, whereby the degree *F*(%) of c axis orientation of a bismuth layer structured compound contained in the dielectric layer 5 is determined, it is therefore possible to obtain a thin film capacitive element 1 having a desired electrostatic capacitance temperature coefficient without providing a plurality of dielectric layers. It is therefore possible to control the temperature dependency of an electronic circuit into which the thin film capacitive element 1 is incorporated in a desired manner, thereby lowering the temperature dependency of the electronic device into which the electronic circuit is incorporated.

Hereinafter, working examples will be set out in order to further clarify the advantages of the present invention.

**Working Example 1**

A toluene solution of strontium 2-ethyl hexanoate, a 2-ethyl hexanoate solution of bismuth 2-ethyl hexanoate and a toluene solution of titanium 2-ethyl hexanoate were mixed so that the mixture contained 1 mole of strontium 2-ethyl hexanoate, $(4 + \alpha)$ moles of bismuth 2-ethyl hexanoate and 4 moles of titanium 2-ethyl hexanoate, namely, so that bismuth (Bi) was present in an amount exceeding that determined by the stoichiometric ratio by $\alpha$ mole, and the resulting mixture was diluted with toluene, thereby preparing a constituent solution.

Here, the constituent solution was prepared so that $\alpha$ was set to 0.4 and that the mole ratio (Bi/Ti) of bismuth (Bi) to titanium (Ti) was 1.1.

On the other hand, a silicon oxide film having a thickness of 0.5 $\mu$m was formed on a support substrate made of silicon single crystal by thermal oxidation of silicon and a lower electrode consisting of a platinum film was formed on the silicon oxide film so as to have a thickness of 0.1 $\mu$m.

Here, the lower electrode was formed by a sputtering process by using argon gas having a pressure of 1 pascal (Pa) as a sputtering gas, setting the temperatures of the support substrate and the silicon oxide film to 600 °C and setting the electric power to 100 W/cm$^2$. The size of the support substrate was 5 mm x 10 mm.

Then, the support substrate was set onto the stage of a spin coating apparatus and the stage was rotated at 4000 rpm for twenty minutes while about 10 microliter of the constituent solution was being dripped onto the surface of the lower electrode, thereby forming a coating layer having a thickness of 100 nm on the surface of the lower electrode.

Thereafter, the support substrate formed with the coating layer was set in a constant temperature bath whose temperature was set to 150 °C and the coating layer was dried for ten minutes, thereby evaporating the solvent contained in the coating layer.

Then, the support substrate formed with the coating layer was placed in a ring furnace into which oxygen gas was being fed at a flow rate of 0.3 liter/minute and the temperature in the ring furnace was increased to 400 °C at a rate of 10 °K/minute. Further, the temperature in the ring furnace was held at 400 °C for ten minutes and was lowered at a rate of 10 °K/minute, thereby provisionally baking the coating layer.

Then, the support substrate formed with the thus provisionally baked coating layer was set onto the stage of a spin coating apparatus and the stage was rotated at 4000 rpm for twenty minutes while about 10 microliter of the constituent solution was being dripped onto the surface of the lower electrode, thereby forming a coating layer having a thickness of 200 nm in total.

Thereafter, the support substrate formed with the coating layer was set in a constant temperature bath whose temperature was set to 150 °C and the coating layer was dried for ten minutes, thereby evaporating the solvent contained in the coating layer.

Then, the support substrate formed with the coating layer was placed in a ring furnace into which oxygen gas was being fed at a flow rate of 0.3 liter/minute and the temperature in the ring furnace was increased to 400 °C at a rate of 10 °K/minute. Further, the temperature in the ring furnace was held at 400 °C for ten minutes and was lowered at a rate of 10 °K/minute, thereby provisionally baking the coating layer.

Further, the support substrate formed with the thus provisionally baked coating layer was set onto the stage of a spin coating apparatus and the stage was rotated at 4000 rpm for twenty minutes while about 10 microliter of the constituent solution was being dripped onto the surface of the lower electrode, thereby forming a coating layer having a thickness of 300 nm in total.

Thereafter, the support substrate formed with the coating layer was set in a constant temperature bath whose temperature was set to 150 °C and the coating layer was dried for ten minutes, thereby evaporating the solvent contained in the coating layer.

Then, the support substrate formed with the coating layer was placed in a ring furnace into which oxygen gas was being fed at a flow rate of 0.3 liter/minute and the temperature in the ring furnace was increased to 400 °C at a rate of 10 °K/minute. Further, the temperature in the ring furnace was held at 400 °C for ten minutes and was lowered at a rate of 10 °K/minute, thereby provisionally baking the coating layer.

Thus, the provisional baking operation was completed. Then, the support substrate formed with the thus provisionally baked coating layer was placed in a ring furnace into which oxygen gas was being fed at a flow rate of 5 mililiter/minute and the temperature in the ring furnace was increased to 860 °C at a rate of 80 °K/minute. Further, the temperature in the ring furnace was held at 860 °C for thirty minutes and was lowered at a rate of 80 °K/minute, thereby baking the coating layer to form a dielectric layer. The thickness of the thus baked dielectric layer was 300 nm.

The crystal structure of the thus obtained dielectric layer was measured using an X-ray diffraction method and the degree $F$(%) of $c$ axis orientation of the bismuth layer structured compound was determined based on the measured X-ray diffraction pattern in accordance with the formula (1). As a result, the degree $F$(%) of $c$ axis orientation of the bismuth layer structured compound was found to be 55 %.

Then, an upper electrode consisting of a platinum film was formed on the surface of the dielectric layer so as to have a thickness of 0.1 $\mu$m.

Here, the upper electrode was formed by a sputtering process by using argon gas having a pressure of 1 pascal (Pa) as a sputtering gas, setting the temperatures of the support substrate, the silicon oxide film, the lower electrode and the dielectric layer to a room temperature (25 °C) and setting the electric power to 100 W. Thus, a thin film capacitive element was fabricated.

The capacitance of the thus fabricated thin film capacitive element was measured using an impedance analyzer (HP4194A) at a frequency of 100 kHz (application of AC 20mV) under the conditions of a reference temperature set to 25 °C and a measured temperature range set to -55 °C to 150 °C, and the average rate of change in the dielectric constant (electrostatic capacitance temperature coefficient) $\Delta\varepsilon$ with respect to temperature was measured by setting the reference temperature to 25 °C. As a result, the average rate of change in the capacitance (electrostatic capacitance temperature coefficient) $\Delta\varepsilon$ was found to be 880 ppm/K.

**Working Example 2**

A dielectric layer was formed in a similar manner to that in Working Example 1 except that the temperature in the ring furnace was increased to 880 °C and was held at 880 °C for thirty minutes when the coating layer formed on the lower electrode was baked, thereby fabricating a thin film capacitive element.

The degree $F$ (%) of $c$ axis orientation of the bismuth layer structured compound contained in the thus obtained dielectric layer was measured in a similar manner to that in Working Example 1. As a result, the degree $F$ (%) of $c$ axis orientation of the bismuth layer structured compound was found to be 60 %.

Further, the average rate of change in the dielectric constant (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be 810 ppm/K.

**Working Example 3**

A dielectric layer was formed in a similar manner to that in Working Example 1 except that the constituent solution was prepared so that $\alpha$ was set to 0.8 and the mole ratio (Bi/Ti) of bismuth (Bi) to titanium (Ti) was equal to 1.2, thereby fabricating a thin film capacitive element.

The degree $F$ (%) of $c$ axis orientation of the bismuth layer structured compound contained in the thus obtained dielectric layer was measured in a similar manner to that in Working Example 1. As a result, the degree $F$ (%) of c axis orientation of the bismuth layer structured compound was found to be 65 %.

Further, the average rate of change in the capacitance (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be 570 ppm/K.

**Working Example 4**

A dielectric layer was formed in a similar manner to that in Working Example 3 except that the temperature in the ring furnace was increased to 900 °C and was held at 900 °C for thirty minutes when the coating layer formed on the lower electrode was baked, thereby fabricating a thin film capacitive element.

The degree $F$ (%) of $c$ axis orientation of the bismuth layer structured compound contained in the thus obtained dielectric layer was measured in a similar manner to that in Working Example 1. As a result, the degree $F$ (%) of $c$ axis orientation of the bismuth layer structured compound was found to be 70 %.

Further, the average rate of change in the dielectric constant (electrostatic capacitance temperature coefficient) $\Delta\varepsilon$ of the thus fabricated thin film capacitive element with respect to temperature was measured in a similar manner to that in Working Example 1.As a result, the average rate of change in the capacitance $\Delta\varepsilon$ of the thin film capacitive element was found to be 450 ppm/K.

**Working Example 5**

A toluene solution of strontium 2-ethyl hexanoate, a 2-ethyl hexanoate solution of bismuth 2-ethyl hexanoate and a toluene solution of titanium 2-ethyl hexanoate were mixed so that the mixture contained 1 mole of strontium 2-ethyl hexanoate, $(4 + \alpha)$ moles of bismuth 2-ethyl hexanoate and 4 moles of titanium 2-ethyl hexanoate, namely, so that bismuth (Bi) was present in an amount exceeding that determined by the stoichiometric ratio by $\alpha$ mole, and the resulting mixture was diluted with toluene, thereby preparing a constituent solution.

Here, the constituent solution was prepared so that $\alpha$ was set to 0.8 and that the mole ratio (Bi/Ti) of bismuth (Bi) to titanium (Ti) was 1.2.

On the other hand, a silicon oxide film having a thickness of 0.5 μm was formed on a support substrate made of silicon single crystal by thermal oxidation of silicon and a lower electrode consisting of a platinum film was formed on the silicon oxide film so as to have a thickness of 0.1 μm.

Here, the lower electrode was formed by a sputtering process by using argon gas having a pressure of 1 pascal (Pa) as a sputtering gas, setting the temperatures of the support substrate and the silicon oxide film to 400 °C and setting the electric power to 100 $W/cm^2$. The size of the support substrate was 5 mm x 10 mm.

Then, the support substrate was set onto the stage of a spin coating apparatus and the stage was rotated at 4000 rpm for twenty minutes while about 10 microliter of the constituent solution was being dripped onto the surface of the lower electrode, thereby forming a coating layer having a thickness of 100 nm on the surface of the lower electrode.

Thereafter, the support substrate formed with the coating layer was set in a constant temperature bath whose temperature was set to 150 °C and the coating layer was dried for ten minutes, thereby evaporating the solvent contained in the coating layer.

Then, the support substrate formed with the coating layer was placed in a ring furnace into which oxygen gas was being fed at a flow rate of 0.3 liter/minute and the temperature in the ring furnace was increased to 400 °C at a rate of 10 °K/minute. Further, the temperature in the ring furnace was held at 400 °C for ten minutes and was lowered at a rate of 10 °K/minute, thereby provisionally baking the coating layer.

Further, the support substrate formed with the thus provisionally baked coating layer was placed in a ring furnace into which oxygen gas was being fed at a flow rate of 5 mililiter/minute and the temperature in the ring furnace was increased to 840 °C at a rate of 80 °K/minute. Furthermore, the temperature in the ring furnace was held at 840 °C for thirty minutes and was lowered at a rate of 80 °K/minute, thereby baking the coating layer.

Then, the support substrate formed with the thus baked coating layer was set onto the stage of a spin coating apparatus and the stage was rotated at 4000 rpm for twenty minutes while about 10 microliter of the constituent solution was being dripped onto the surface of the lower electrode, thereby forming a coating layer having a thickness of 200 nm in total.

Thereafter, the support substrate newly formed with the coating layer was set in a constant temperature bath whose temperature was set to 150 °C and the coating layer was dried for ten minutes, thereby evaporating the solvent contained in the coating layer.

Then, the support substrate formed with the coating layer was placed in a ring furnace into which oxygen gas was being fed at a flow rate of 0.3 liter/minute and the temperature in the ring furnace was increased to 400 °C at a rate of 10 °K/minute. Further, the temperature in the ring furnace was held at 400 °C for ten minutes and was lowered at a rate of 10 °K/minute, thereby provisionally baking the newly formed coating layer.

Further, the support substrate formed with the thus provisionally baked coating layer was placed in a ring furnace into which oxygen gas was being fed at a flow rate of 5 mililiter/minute and the temperature in the ring furnace was increased to 840 °C at a rate of 80 °K/ minute. Furthermore, the temperature in the ring furnace was held at 840 °C for thirty minutes and was lowered at a rate of 80 °K/minute, thereby baking the newly formed coating layer.

Then, the support substrate formed with the thus baked coating layer was set onto the stage of a spin coating apparatus and the stage was rotated at 4000 rpm for twenty minutes while about 10 microliter of the constituent solution was being dripped onto the surface of the lower electrode, thereby forming a coating layer having a thickness of 300 nm in total.

Thereafter, the support substrate newly formed with the coating layer was set in a constant temperature bath whose temperature was set to 150 °C and the coating layer was dried for ten minutes, thereby evaporating the solvent contained in the coating layer.

Then, the support substrate newly formed with the coating layer was placed in a ring furnace into which oxygen gas was being fed at a flow rate of 0.3 liter/ minute and the temperature in the ring furnace was increased to 400 °C at a rate of 10 °K/minute. Further, the temperature in the ring furnace was held at 400 °C for ten minutes and was lowered at a rate of 10 °K/minute, thereby provisionally baking the newly formed coating layer.

Further, the support substrate formed with the thus provisionally baked coating layer was placed in a ring furnace into which oxygen gas was being fed at a flow rate of 5 mililiter/minute and the temperature in the ring furnace was increased to 840 °C at a rate of 80 °K/ minute. Furthermore, the temperature in the ring furnace was held at 840 °C for thirty minutes and was lowered at a rate of 80 °K/minute, thereby baking the newly formed coating layer to form a dielectric layer. The thickness of the thus baked dielectric layer was 300 nm.

The degree *F* (%) of *c* axis orientation of the bismuth layer structured compound contained in the thus obtained dielectric layer was measured in a similar manner to that in Working Example 1. As a result, the degree *F* (%) of c axis orientation of the bismuth layer structured compound was found to be 80 %.

Further, an upper electrode was formed on the surface of the dielectric layer in a similar manner to that in Working Example 1, thereby fabricating a thin film capacitive element.

Moreover, the average rate of change in the dielectric constant (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be 300 ppm/K.

**Working Example 6**

A dielectric layer was formed in a similar manner to that in Working Example 5 except that the temperature in the ring furnace was increased to 860 °C and was held at 860 °C for thirty minutes when the coating layer formed on the lower electrode was baked, thereby fabricating a thin film capacitive element.

The degree *F* (%) o *c* axis f orientation of the bismuth layer structured compound contained in the thus obtained dielectric layer was measured in a similar manner to that in Working Example 1. As a result, the degree *F*(%) of orientation of the bismuth layer structured compound contained in the *c* axis direction thereof was found to be 90 %.

Further, the average rate of change in the dielectric constant (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be 110 ppm/K.

**Working Example 7**

A dielectric layer was formed in a similar manner to that in Working Example 5 except that the temperature in the ring furnace was increased to 880 °C and was held at 880 °C for thirty minutes when the coating layer formed on the lower electrode was baked, thereby fabricating a thin film capacitive element.

The degree *F* (%) of *c* axis orientation of the bismuth layer structured compound contained in the thus obtained dielectric layer was measured in a similar manner to that in Working Example 1. As a result, the degree *F* (%) of *c* axis orientation of the bismuth layer structured compound was found to be 94 %.

Further, the average rate of change in the dielectric constant (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be 0 ppm/K.

**Working Example 8**

A dielectric layer was formed in a similar manner to that in Working Example 6 except that the constituent solution was prepared so that $\alpha$ was set to 1.2 and the mole ratio (Bi/Ti) of bismuth (Bi) to titanium (Ti) was equal to 1.3, thereby fabricating a thin film capacitive element.

The degree $F$ (%) of $c$ axis orientation of the bismuth layer structured compound contained in the thus obtained dielectric layer was measured in a similar manner to that in Working Example 1. As a result, the degree $F$ (%) of $c$ axis orientation of the bismuth layer structured compound was found to be 95 %.

Further, the average rate of change in the dielectric constant (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be -30 ppm/K.

**Working Example 9**

A dielectric layer was formed in a similar manner to that in Working Example 8 except that the temperature in the ring furnace was increased to 880 °C and was held at 880 °C for thirty minutes when the coating layer formed on the lower electrode was baked, thereby fabricating a thin film capacitive element.

The degree $F$ (%) of $c$ axis orientation of the bismuth layer structured compound contained in the thus obtained dielectric layer was measured in a similar manner to that in Working Example 1. As a result, the degree $F$ (%) of $c$ axis orientation of the bismuth layer structured compound was found to be 97 %.

Further, the average rate of change in the dielectric constant (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be -90 ppm/K.

**Working Example 10**

A dielectric layer was formed in a similar manner to that in Working Example 7 except that the constituent solution was prepared so that $\alpha$ was set to 1.6 and the mole ratio (Bi/Ti) of bismuth (Bi) to titanium (Ti) was equal to 1.4, thereby fabricating a thin film capacitive element.

The degree $F$ (%) of c axis orientation of the bismuth layer structured compound contained in the thus obtained dielectric layer was measured in a similar manner to that in Working Example 1. As a result, the degree $F$ (%) of $c$ axis orientation of the bismuth layer structured compound was found to be 100 %.

Further, the average rate of change in the dielectric constant (electrostatic capacitance temperature coefficient) $\Delta\varepsilon$ of the thus fabricated thin film capacitive element with respect to temperature was measured in a similar manner to that in Working Example 1. As a result, the average rate of change in the capacitance $\Delta\varepsilon$ of the thin film capacitive element was found to be -150 ppm/K.

Figure 2 is a graph showing the relationship between the average rate of change in the dielectric constant (electrostatic capacitance temperature coefficient) $\Delta\varepsilon$ of each of the thin film capacitive elements fabricated in Working Examples 1 to 10 with respect to temperature and the degree $F$ of $c$ axis orientation of the bismuth layer structured compound contained in the dielectric layer for constituting each of the thin film capacitive elements.

As shown in Figure 2, it was found that the average rate of change in the dielectric constant (electrostatic capacitance temperature coefficient) $\Delta\varepsilon$ of the thin film capacitive element formed with the dielectric layer containing the bismuth layer structured compound having a composition represented by the stoichiometric compositional formula: $SrBi_4Ti_4O_{15}$ but containing bismuth in an amount exceeding that determined by the stoichiometric ratio decreased linearly from a plus value to a minus value as the degree $F$ of $c$ axis orientation of the bismuth layer structured compound contained in the dielectric layer for constituting the thin film capacitive element increased.

Thus it was possible to fabricate a thin film capacitive element having a desired electrostatic capacitance temperature coefficient by controlling the excessive amount of bismuth (Bi) with respect to the stoichiometric ratio, coating conditions, provisional baking conditions and baking conditions for forming the dielectric layer to control the degree $F$ (%) of $c$ axis orientation of the bismuth layer structured compound contained in the dielectric layer. It was therefore found possible to control the temperature dependency of an electronic circuit in a desired manner by incorporating therein a thin film capacitive element formed with a dielectric layer containing the bismuth layer structured compound having a composition represented by the stoichiometric

compositional formula: $SrBi_4Ti_4O_{15}$ but containing bismuth (Bi) in an amount exceeding that determined by the stoichiometric ratio so that the temperature dependency of an electronic device into which the electronic circuit was incorporated could be lowered.

The present invention has thus been shown and described with reference to a specific preferred embodiment. However, it should be noted that the present invention is in no way limited to the details of the described arrangement but changes and modifications may be made without departing from the scope of the appended claims.

In the above described preferred embodiments, for example, the dielectric layer 5 of the thin film capacitive element 1 is formed of the dielectric material containing the bismuth layer structured compound having a composition represented by the stoichiometric compositional formula: $SrBi_4Ti_4O_{15}$ but containing bismuth (Bi) in such an amount exceeding that determined by the stoichiometric ratio that the mole ratio (Bi/Ti) of bismuth (Bi) to titanium (Ti) is larger than 1 and smaller than 1.5. However, it is not absolutely necessary to form the dielectric layer 5 of the thin film capacitive element 1 of a dielectric material containing a bismuth layer structured compound having a composition represented by the stoichiometric compositional formula: $SrBi_4Ti_4O_{15}$ but containing bismuth (Bi) in such an amount exceeding that determined by the stoichiometric ratio that the mole ratio (Bi/Ti) of bismuth (Bi) to titanium (Ti) is larger than 1 and smaller than 1.5. It is sufficient for the dielectric layer 5 of the thin film capacitive element 1 to be formed of a dielectric material containing a bismuth layer structured compound having a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$ but containing bismuth (Bi) in such an amount exceeding that determined by the stoichiometric ratio that bismuth (Bi) is excessive in an amount larger than 0 and smaller than $0.5m$ mole in terms of bismuth (Bi)., where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined, and the dielectric layer 5 of a thin film capacitive element 1 is preferably formed of a dielectric material containing a bismuth layer structured compound containing bismuth (Bi) so that the excessive amount thereof is equal to or larger than $0.4m$ mole and smaller than $0.5m$ mole in terms of bismuth (Bi). Furthermore, it is possible to form the dielectric layer 5 of the thin film capacitive element 1 of a dielectric material containing a bismuth layer structured compound having a composition represented by the stoichiometric compositional formula: $xSbBi_4Ti_4O_{15}$-(1 - $x$)$MBi_4Ti_4O_{15}$ but containing bismuth (Bi) in such an amount exceeding that determined by the stoichiometric ratio that bismuth (Bi) is excessive in an amount larger than 0 and smaller than 0.2 mole in terms of bismuth, where the symbol $M$ is at least one element selected from among calcium, barium and lead and the symbol $x$ is equal to or larger than 0 and equal to or smaller than 1. It is further possible to form the dielectric layer 5 of the thin film capacitive element 1 of a dielectric material containing a bismuth layer structured compound having a composition represented by the stoichiometric compositional formula: $xSbBi_4Ti_4O_{15}$-(1 - $x$)$MBi_4Ti_4O_{15}$ but containing bismuth (Bi) in such an amount exceeding that determined by the stoichiometric ratio that the mole ratio (Bi/Ti) of bismuth (Bi) to titanium (Ti) is larger than 1 and smaller than 1.5, where the symbol $M$ is at least one element selected from among calcium, barium and lead and the symbol $x$ is equal to or larger than 0 and equal to or smaller than 1. Moreover, it is possible to form the dielectric layer 5 of the thin film capacitive element 1 of a dielectric material containing a bismuth layer structured compound having a composition represented by the stoichiometric compositional formula: $SrBi_4Ti_4O_{15}$ but containing bismuth (Bi) in such an amount exceeding that determined by the stoichiometric ratio that bismuth (Bi) is excessive in an amount larger than 0 and smaller than 0.2 mole in terms of bismuth.

Further, in each of the above described preferred embodiment and Working Examples 1 to 10, although the coating layers are formed using a spin coating process when the dielectric layer 5 is to be formed, it is not absolutely necessary to form the coating layers using a spin coating process and the coating layers may be formed using a dip coating process, for example, instead of a spin coating process.

Furthermore, in each of the above described preferred embodiment and Working Examples 1 to 10, although the support substrate 2 of the thin film capacitive element 1 is formed of silicon single crystal, it is not absolutely necessary to form a support substrate 2 of a thin film capacitive element 1 of silicon single crystal and it is possible to employ a support substrate 2 formed of single crystal having a small lattice mismatch such as $SrTiO_3$ single crystal, MgO single crystal, $LaAlO_3$ single crystal or the like, an amorphous material such as glass, fused silica, $SiO_2$/Si or the like, and another material such as $ZrO_2$/Si, $CeO_2$/Si or the like.

Moreover, in each of the above described preferred embodiment and Working Examples 1 to 10, although the lower electrode layer 4 of the thin film capacitive element 1 is formed of platinum, it is not absolutely necessary to form a lower electrode layer 4 of a thin film capacitive element 1 of platinum and it is possible to form a lower electrode layer 4 of a thin film capacitive element 1 of a conductive oxide such as $SrMoO_3$, $SrRuO_3$, $CaRuO_3$, $SrVO_3$, $SrCrO_3$, $SrCoO_3$, $LaNiO_3$, Nb

doped $SrTiO_3$ or the like, a noble metal such as lutetium, gold, palladium, silver or the like, an alloy of these, conductive glass such as ITO or the like, a base metal such as nickel, copper or the like or an alloy of these, or the like. In the case where the support substrate 2 is formed of a material having a small lattice mismatch, it is preferable for a lower electrode layer 4 of a thin film capacitive element 1 to be formed of a conductive oxide such as $CaRuO_3$, $SrRuO_3$ or the like, or a noble metal such as platinum, lutetium or the like.

Further, in each of the above described preferred embodiment and Working Examples 1 to 10, although the lower electrode layer 4 of the thin film capacitive element 1 is formed using a sputtering process, it is not absolutely necessary to form a lower electrode layer 4 of a thin film capacitive element 1 using a sputtering process and a lower electrode layer 4 of a thin film capacitive element 1 can be formed using any of other thin film forming processes such as a vacuum deposition process, a pulsed laser deposition process (PLD), a metal organic chemical vapor deposition process (MOCVD), a chemical solution deposition process (CSD process) and the like.

Furthermore, in each of the above described preferred embodiment and Working Examples 1 to 10, although the dielectric layer 5 of the thin film capacitive element 1 is formed using a metal-organic decomposition process (MOD), it is not absolutely necessary to form a dielectric layer 5 of a thin film capacitive element 1 using a metal-organic decomposition process (MOD) and a dielectric layer 5 of a thin film capacitive element 1 can be formed using any of other thin film forming processes such as a vacuum deposition process, a sputtering process, a pulsed laser deposition process (PLD), a metal organic chemical vapor deposition process (MOCVD), another chemical solution deposition process (CSD process) such as a sol-gel process or the like. Among these, a metal-organic decomposition process or a chemical solution deposition process such as a sol-gel process or the like is preferable used for forming a dielectric layer 5 of a thin film capacitive element 1.

Moreover, in each of the above described preferred embodiment and Working Examples 1 to 10, although the constituent solution is applied onto the lower electrode layer 4 using a spin coating process when the dielectric layer 5 is to be formed, it is not absolutely necessary to apply a constituent solution onto a lower electrode layer 4 using a spin coating process and it is possible to apply a constituent solution onto a lower electrode layer 4 using any of other coating processes such as a dip coating process, a spray coating process or the like.

Further, in each of the above described preferred embodiment and Working Examples 1 to 10, although the upper electrode layer 6 of the thin film capacitive element 1 is formed of platinum, it is not absolutely necessary to form an upper electrode layer 6 of a thin film capacitive element 1 of platinum and an upper electrode layer 6 of a thin film capacitive element 1 can be formed of a conductive oxide such as NdO, NbO, $ReO_2$, $RhO_2$, $OsO_2$, $IrO_2$, $RuO_2$, $ReO_3$, $SrMoO_3$, $SrRuO_3$, $CaRuO_3$, $SrVO_3$, $SrCrO_3$, $SrCoO_3$, $LaNiO_3$, Nb doped $SrTiO_3$ or the like, a noble metal such as lutetium, gold, palladium, silver or the like, an alloy of these, conductive glass such as ITO or the like, a base metal such as nickel, copper or the like or an alloy of these.

Furthermore, in each of the above described preferred embodiment and Working Examples 1 to 10, although the upper electrode layer 6 of the thin film capacitive element 1 is formed using a sputtering process, it is not absolutely necessary to form an upper electrode layer 6 of a thin film capacitive element 1 using a sputtering process and an upper electrode layer 6 of a thin film capacitive element 1 can be formed using any of other thin film forming processes such as a vacuum deposition process, a pulsed laser deposition process (PLD), a metal organic chemical vapor deposition process (MOCVD), a chemical solution deposition process (CSD process) and the like.

According to the present invention, it is possible to provide a thin film capacitive element which can be made thin, can be fabricated easily and has an excellent temperature compensating characteristic, and an electronic circuit and electronic device including the thin film capacitive element.

## Claims

1. A thin film capacitive element including between a first electrode layer and a second electrode layer a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$ but containing bismuth (Bi) in such an amount exceeding that determined by the stoichiometric ratio, that bismuth (Bi) is excessive in an amount larger than 0 and smaller than $0.5m$ mole in terms of bismuth (Bi), where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

2. A thin film capacitive element in accordance with Claim 1, wherein the dielectric layer contains a bismuth layer structured compound containing bismuth (Bi) in such an amount exceeding that that determined by the stoichiometric ratio that bismuth (Bi) is excessive in an amount equal to or larger than 0.4$m$ mole and smaller than 0.5$m$ mole in terms of bismuth (Bi).

3. A thin film capacitive element in accordance with Claim 1, wherein the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

4. A thin film capacitive element in accordance with Claim 2, wherein the dielectric layer is formed using a chemical solution deposition process.

5. A thin film capacitive element including between a first electrode layer and a second electrode layer a dielectric layer formed of a dielectric material having a composition represented by the stoichiometric compositional formula: $x$SbBi$_4$Ti$_4$O$_{15}$-(1 - $x$) $M$Bi$_4$Ti$_4$O$_{15}$ but containing bismuth (Bi) in such an amount exceeding that determined by the stoichiometric ratio that bismuth (Bi) is excessive in an amount larger than 0 and smaller than 2.0 mole in terms of bismuth, where the symbol $M$ is at least one element selected from among calcium, barium and lead and the symbol $x$ is equal to or larger than 0 and equal to or smaller than 1.

6. A thin film capacitive element in accordance with Claim 5, wherein the dielectric layer contains a bismuth layer structured compound having a composition represented by the stoichiometric compositional formula: SrBi$_4$Ti$_4$O$_{15}$.

7. A thin film capacitive element in accordance with Claim 5, wherein the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

8. A thin film capacitive element in accordance with Claim 5, wherein the dielectric layer is formed using a chemical solution deposition process.

9. A thin film capacitive element including between a first electrode layer and a second electrode layer a dielectric layer formed of a dielectric material having a composition represented by the stoichiometric compositional formula: $x$SbBi$_4$Ti$_4$O$_{15}$-(1 - $x$) $M$Bi$_4$Ti$_4$O$_{15}$ but containing bismuth (Bi) in such an amount exceeding that determined by the stoichiometric ratio that the mole ratio (Bi/Ti) of bismuth (Bi) to titanium (Ti) is larger than 1 and smaller than 1.5, where the symbol $M$ is at least one element selected from among calcium, barium and lead and the symbol x is equal to or larger than 0 and equal to or smaller than 1.

10. A thin film capacitive element in accordance with Claim 9, wherein the dielectric layer contains a bismuth layer structured compound represented by the stoichiometric compositional formula: SrBi$_4$Ti$_4$O$_{15}$.

11. A thin film capacitive element in accordance with Claim 9, wherein the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

12. A thin film capacitive element in accordance with Claim 9, wherein the dielectric layer is formed using a chemical solution deposition process.

13. An electronic circuit including a thin film capacitive element including between a first electrode layer and a second electrode layer a dielectric layer formed of a dielectric material containing a bismuth layer structured compound having a composition represented by the stoichiometric compositional formula: (Bi$_2$O$_2$)$^{2+}$ ($A_{m-1}B_m$O$_{3m+1}$)$^{2-}$ or Bi$_2A_{m-1}B_m$O$_{3m+3}$ but containing bismuth (Bi) in such an amount exceeding that determined by the stoichiometric ratio that bismuth (Bi) is excessive in an amount larger than 0 and smaller than 0.5$m$ mole in terms of bismuth (Bi), where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

14. An electronic device including a thin film capacitive element including between a first electrode layer and a second electrode layer a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$ but containing bismuth (Bi) in such an amount exceeding that determined by the stoichiometric ratio that bismuth (Bi) is excessive in an amount larger than 0 and smaller than $0.5m$ mole in terms of bismuth (Bi), where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

15. An electronic device in accordance with Claim 14, wherein the dielectric layer contains a bismuth layer structured compound containing bismuth (Bi) in such an amount exceeding that determined by the stoichiometric ratio that bismuth (Bi) is excessive in an amount equal to or larger than $0.4m$ mole and smaller than $0.5m$ mole in terms of bismuth (Bi).

16. An electronic device in accordance with Claim 14, wherein the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

17. An electronic device in accordance with Claim 14, wherein the dielectric layer is formed on the first electrode layer using a chemical solution deposition process.

18. An electronic device including a thin film capacitive element including between a first electrode layer and a second electrode layer a dielectric layer formed of a dielectric material containing a bismuth layer structured compound having a composition represented by the stoichiometric compositional formula: $x$SbB$_{14}$T$_{14}$O$_{15}$-(1 - $x$)$M$Bi$_4$T$_{14}$O$_{15}$ but containing bismuth (Bi) in such an amount exceeding that determined by the stoichiometric ratio that bismuth (Bi) is excessive in an amount larger than 0 and smaller than 2.0 mole in terms of bismuth, where the symbol $M$ is at least one element selected from among calcium, barium and lead and the symbol $x$ is equal to or larger than 0 and equal to or smaller than 1.

19. An electronic device in accordance with Claim 18, wherein the dielectric layer contains a bismuth layer structured compound represented by the stoichiometric compositional formula: $SrBi_4Ti_4O_{15}$.

20. An electronic device in accordance with Claim 18, wherein the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

21. An electronic device in accordance with Claim 18, wherein the dielectric layer is formed on the first electrode layer using a chemical solution deposition process.

22. An electronic device including a thin film capacitive element including between a first electrode layer and a second electrode layer a dielectric layer formed of a dielectric material containing a bismuth layer structured compound having a composition represented by the stoichiometric compositional formula: $x$SbBi$_4$Ti$_4$O$_{15}$-(1 - $x$)$M$Bi$_4$Ti$_4$O$_{15}$ but containing bismuth (Bi) in such an amount exceeding that determined by the stoichiometric ratio that the mole ratio (Bi/Ti) of bismuth (Bi) to titanium (Ti) is larger than 1 and smaller than 1.5, where the symbol $M$ is at least one element selected from among calcium, barium and lead and the symbol $x$ is equal to or larger than 0 and equal to or smaller than 1.

23. An electronic device in accordance with Claim 22, wherein the dielectric layer contains a bismuth layer structured compound represented by the stoichiometric compositional formula: $SrBi_4Ti_4O_{15}$.

24. An electronic device in accordance with Claim 22, wherein the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

25. An electronic device in accordance with Claim 22, wherein the dielectric layer is formed on the first electrode layer using a chemical solution deposition process.

FIG. 1

FIG. 2

<table>
<tr><td colspan="2" align="center"><strong>INTERNATIONAL SEARCH REPORT</strong></td><td colspan="2">International application No.<br>PCT/JP2004/001977</td></tr>
</table>

**A. CLASSIFICATION OF SUBJECT MATTER**
Int.Cl$^7$  H01L27/04, H01L27/10, H01G4/33, H01G4/12, C04B35/453, C01G29/00

According to International Patent Classification (IPC) or to both national classification and IPC

**B. FIELDS SEARCHED**

Minimum documentation searched (classification system followed by classification symbols)
Int.Cl$^7$  H01L27/04, H01L27/10, H01G4/33, H01G4/12, C04B35/453, C01G29/00

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2004 |
| Kokai Jitsuyo Shinan Koho | 1971–2004 | Toroku Jitsuyo Shinan Koho | 1994–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2000-169297 A  (Sharp Corp.),<br>20 June, 2000 (20.06.00),<br>Par. Nos. [0008] to [0009], [0024]<br>& US 2002/153543 A1 | 1-2,4-6,<br>8-10,12-15,<br>17-19,21-23,<br>25 |
| Y | | 3,7,11,16,<br>20,24 |
| X | JP 10-56142 A  (Oki Electric Industry Co., Ltd.),<br>24 February, 1998 (24.02.98),<br>Par. Nos. [0020] to [0035]<br>& EP 810666 A1 | 1-2,4-6,<br>8-10,12-15,<br>17-19,21-23,<br>25 |
| Y | | 3,7,11,16,<br>20,24 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>13 May, 2004 (13.05.04) | Date of mailing of the international search report<br>01 June, 2004 (01.06.04) |
| Name and mailing address of the ISA/<br>Japanese Patent Office | Authorized officer |
| Facsimile No. | Telephone No. |

Form PCT/ISA/210 (second sheet) (January 2004)

**EP 1 598 870 A1**

<table>
<tr><td colspan="2" align="center">**INTERNATIONAL SEARCH REPORT**</td><td>International application No.<br>PCT/JP2004/001977</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 9-25124 A  (Mitsubishi Materials Corp.),<br>28 January, 1997 (28.01.97),<br>Par. No. [0026]<br>& US 5807495 A | 3,7,11,16,<br>20,24 |
| Y | JP 9-31635 A  (Mitsubishi Materials Corp.),<br>04 February, 1997 (04.02.97),<br>Par. No. [0022]<br>& US 5807495 A | 3,7,11,16,<br>20,24 |

Form PCT/ISA/210 (continuation of second sheet) (January 2004)